# EUROPEAN PATENT SPECIFICATION

(11) **EP 3 113 241 B1**
(45) Date of publication and mention of the grant of the patent: **01.09.2021**
(21) Application number: 16176908.8
(22) Date of filing: 29.06.2016
(51) Int. Cl.: H01L 51/52

(54) **ORGANIC LIGHT EMITTING DISPLAY DEVICE**
ORGANISCHE LICHTEMITTIERENDE ANZEIGEVORRICHTUNG
DISPOSITIF ÉLECTROLUMINESCENT ORGANIQUE

(30) Priority: 30.06.2015 KR 20150093786
(43) Date of publication of application: 04.01.2017
(73) Proprietor: LG Display Co., Ltd., Yeongdeungpo-gu Seoul, 07336 (KR)
(72) Inventor: KIM, ByoungChul, 54089 Jeollabuk-do (KR); CHOI, Wonyeol, 10446 Gyeonggi-do (KR); PARK, Heesung, 46323 Busan (KR)
(74) Representative: Ter Meer Steinmeister & Partner

(56) References cited:
- EP-A2- 2 869 345
- WO-A2-2008/069930
- US-A1- 2003 164 674
- US-A1- 2005 156 513
- US-A1- 2013 328 480
- US-A1- 2014 175 403
- US-A1- 2014 353 625
- US-A1- 2014 367 661
- None

## Description

### CROSS-REFERENCE TO RELATED APPLICATIONS

This application claims the priority of Korean Patent Application No. 10-2015-0093786 filed on June 30, 2015, in the Korean Intellectual Property Office.

### BACKGROUND

### Field

The present disclosure relates to an encapsulation structure of an organic light emitting display device.

### Description of the Related Art

Image display devices that realize various types of information on the screen are based on core technologies of the information and telecommunication age and are being developed into thinner, lighter-weight, portable and high-performance forms. Thus, recently an organic light emitting display device configured to display an image by controlling the amount of light emitted from an organic light emitting layer has attracted a lot of attention.

The organic light emitting display device is a self-emitting device using an emission layer between electrodes and can be manufactured into a thin film. A general organic light emitting display device has a structure in which a pixel driving circuit and an organic light emitting element are formed on a substrate. Further, the general organic light emitting display device displays an image when a light emitted from the organic light emitting element passes through the substrate or a barrier layer. However, in the organic light emitting element, deterioration caused by internal factors, such as deterioration of an electrode and an emission layer caused by oxygen and deterioration caused by a reaction between the emission layer and an interface, occurs. Also, in the organic light emitting element, deterioration caused by external factors such as moisture, oxygen and UV light, and manufacturing conditions of the element, easily occurs. Particularly, oxygen and moisture have deadly effects on the organic light emitting element. Accordingly, packaging of the organic light emitting display device is very important.

One of the packaging methods is to seal a substrate on which an organic light emitting element is formed with a protection cap or layer. Before sealing with the protection cap, moisture absorbent material can be bonded to an inner central portion of the protection cap so as to absorb moisture which may be present therein. Further, in order to suppress the moisture absorbent from falling onto an organic layer, a semi-permeable film that allows moisture and oxygen to come in and out is bonded to a back surface of the protection cap.

The protection cap that seals the organic light emitting element is formed of an organic/inorganic material in order to suppress permeation of moisture. However, during a scribing process, impacts may be applied to an inorganic film, resulting in a crack. This crack may be spread by an external force or the like and thus undesirably serves as a moisture-permeation path.

US 2005/156513 A1 describes an array substrate that includes organic EL elements. A sealer is placed to cover at least an effective portion of the major surface of the array substrate. The sealer includes at least two buffer layers and barrier layers.

US 2003/164674 A1 describes a sealing structure that comprises a multi-layered resin membrane for sealing an electronic element section disposed on a substrate, which is formed by alternately depositing flattening resin layers and barriers layers on the substrate. US 2013/328480 A1 discloses a flat panel display. A plurality of organic light-emitting display devices is formed on a substrate. The substrate is cut along a cutting line and is split into the plurality of organic light-emitting display devices. The substrate includes first regions and a second region disposed at locations corresponding to the plurality of organic light-emitting display devices. The second region includes the cutting line. A display unit is disposed in each of the first regions. A barrier is disposed at an outer side of each of the display units and is formed on the substrate.

US 2014/367661 A1 describes an electro-optic device that includes a substrate that has a first surface and an end face crossing the first surface; a light emitting element that is disposed on the first surface; a planarization layer that covers the light emitting element; and a first inorganic sealing layer that is disposed on the planarization layer. An outer edge of the first inorganic sealing layer is disposed between an outer edge of the planarization layer and a first region where the light emitting element is disposed.

US 2014/353625 A1 describes an organic light emitting diodes display that includes a substrate, a display unit, a thin film encapsulating layer, and a polarization film.

US2014/0175403 discloses an organic light emitting device comprising a protection film having a round corner.

### SUMMARY

An object to be achieved by the present disclosure is to provide an organic light emitting display device and an encapsulation structure used therein. More specifically, the object of the present disclosure is to provide a structure that suppresses cracks in a face seal formed as a multi-layer in order to suppress permeation of moisture into an organic light emitting element. Further, another object to be achieved by the present disclosure is to provide a method for applying the crack suppression structure to an organic light emitting display device. The objects are solved by the features of the independent claims.

According to an aspect of the present disclosure, there is provided an organic light emitting display device as disclosed in claim 1.

According to yet another aspect of the present disclosure, there is provided a manufacturing method of an organic light emitting display device as described in claim 11.

Further aspects of the present invention are defined in the dependent claims.

According to an exemplary embodiment of the present disclosure, it is possible to minimize damage to an encapsulation layer formed into a multi-layer structure. Further, it is possible to suppress permeation of moisture caused by the spread of a crack in an organic light emitting display device.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a plane view illustrating an organic light emitting display device according to exemplary embodiments of the present disclosure;
FIG. 2 is a cross-sectional view illustrating a part of an active area of an organic light emitting display device according to exemplary embodiments of the present disclosure;
FIG. 3A through FIG. 3D are diagrams illustrating an organic light emitting display device and an encapsulation layer according to an exemplary embodiment, not being part of the claimed invention;
FIG. 4A through FIG. 4D are diagrams illustrating an organic light emitting display device according to another exemplary embodiment of the present disclosure; Figures 4A, 4D, not being part of the claimed invention, figures 4B, 4C, according to the claimed invention; and
FIG. 5 is a flowchart illustrating a manufacturing method of an organic light emitting display device according to exemplary embodiments of the present disclosure.

### DETAILED DESCRIPTION OF THE PREFERRED EMBODIMENT

In describing components of the present disclosure, terms such as first, second, A, B, (a), and (b), can be used. These terms are used only to differentiate the components from other components. Therefore, the nature, order, sequence, or number of the corresponding components is not limited by these terms. It is to be understood that when one element is referred to as being "connected to" or "coupled to" another element, it may be directly connected to or directly coupled to another element, connected to or coupled to another element, having still another element "intervening" therebetween, or "connected to" or "coupled to" another element via still another element. When an element or layer is referred to as being "on" another element or layer, it may be directly on the other element or layer, or intervening elements or layers may be present. Since size and thickness of each component illustrated in the drawings are represented for convenience in explanation, the present disclosure is not necessarily limited to the illustrated size and thickness of each component.

The term "organic light emitting display device" which may also be referred to as "display device" herein is used as a general term for an organic light emitting diode panel and a display device employing the organic light emitting diode panel. Generally, the organic light emitting display device is classified into two different types: a white organic emission type; and an RGB organic emission type. In the white organic emission type, each of sub-pixels in a pixel is configured to emit a white light and a set of color filters is used to filter a white light in order for the corresponding sub-pixels to generate red, green, and blue lights. Furthermore, the white organic emission type may include a sub-pixel without a color filter in order to form a sub-pixel for generating a white light. In the RGB organic emission type, an organic emission layer in each sub-pixel is configured to emit a light of a predetermined color. For example, a pixel includes a red sub-pixel including an organic emission layer configured to emit a red light, a green sub-pixel including an organic emission layer configured to emit a green light, and a blue sub-pixel including an organic emission layer configured to emit a blue light.

The features of various embodiments of the present disclosure can be partially or entirely bonded to or combined with each other and can be interlocked and operated in technically various ways as can be fully understood by a person having ordinary skill in the art, and the embodiments can be carried out independently of or in association with each other. Hereinafter, various exemplary embodiments of the present disclosure will be described in detail with reference to the accompanying drawings.

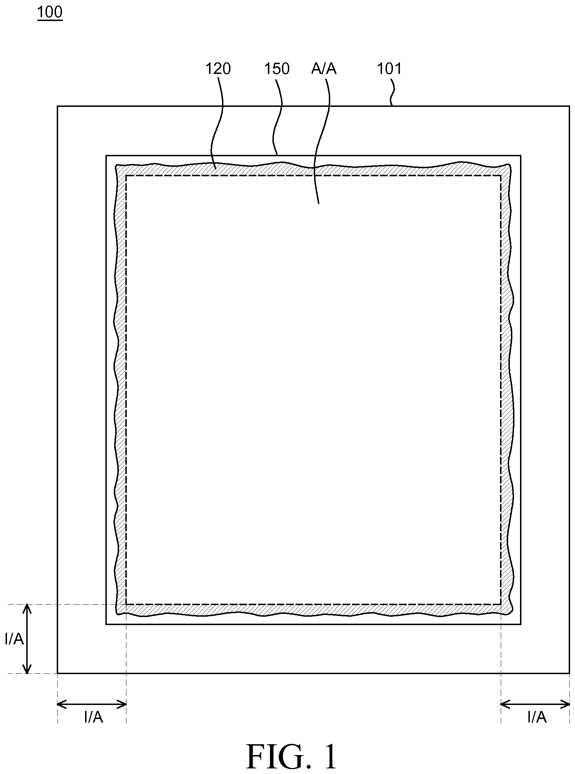

FIG. 1 is a plane view illustrating an organic light emitting display device according to exemplary embodiments of the present disclosure.

Referring to FIG. 1, an organic light emitting display device 100 includes at least one active area (A/A). In the active area, an array of pixels is disposed. One or more inactive areas (I/A) may be disposed around the active area. That is, the inactive area may be adjacent to one or more sides of the active area. In FIG. 1, the inactive area surrounds the active area formed into a square shape. However, the shape of the active area and the shape/arrangement of the inactive area adjacent to the active area are not limited to the example illustrated in FIG. 1. The active area and the inactive area may have a shape suitable for the design of an electronic device equipped with the display device 100. Exemplary shapes of the active area may include a pentagonal shape, a hexagonal shape, a circular shape, an oval shape, and the like.

Each pixel in the active area may be connected to a pixel circuit. The pixel circuit may include one or more switching transistors and one or more driving transistors. Each pixel circuit may be electrically connected to a gate line and a data line in order to communicate with one or more driving circuits, such as a gate driver and a data driver, located in the inactive area.

The driving circuit may be implemented with a thin film transistor (TFT) in the inactive area. The driving circuit may be referred to as a gate-in-panel (GIP). Further, some components such as a data driver IC are mounted on a separate printed circuit board. Also, the components may be combined with a connection interface (pad, bump, pin, and the like) disposed in the inactive area using a circuit film such as a flexible printed circuit board (FPCB), a chip-on-film (COF), and a tape-carrier-package (TCP). The printed circuit board (COF, PCB, and the like) may be located on the back side of the display device 100.

The organic light emitting display device 100 may include various additional components for generating various signals or driving the pixels in the active area. The additional components for driving pixels may include an inverter circuit, a multiplexer, an electro static discharge circuit, and the like. The organic light emitting display device 100 may also include additional components relating to other functions besides driving pixels. For example, the organic light emitting display device 100 may include additional components that provide a touch sensing function, a user authentication function (for example: fingerprint recognition), a multi-level pressure sensing function, a tactile feedback function, and the like. The above-described additional components may be located in an external circuit connected to the inactive area and/or the connection interface.

The organic light emitting display device according to the present disclosure may include a substrate 101 on which a TFT and an organic light emitting element are formed, a seal on the substrate, and a barrier film 150 bonded between the substrate and the seal. The substrate includes a switching TFT formed thereon, a driving TFT connected to the switching TFT, and an organic light emitting element connected to the driving TFT.

The substrate 101 includes an active area (A/A) where image information is displayed and an inactive area (I/A) surrounding the active area. In the active area, the switching TFT, the driving TFT, and the organic light emitting element are formed. In the inactive area, a gate pad, a data pad, a driving current line pad, and the like, are formed. Further, an encapsulation layer 120 for suppressing permeation of moisture and/or a gas such as oxygen may be coated on the components formed in the active area.

The encapsulation layer 120 is coated inside the barrier film 150. The encapsulation layer 120 may be coated so as to have an enough area to entirely cover the active area of the TFT substrate. To be more specific, the encapsulation layer 120 may be coated such that a periphery of the encapsulation layer 120 is disposed between a periphery of the barrier film 150 and a periphery of the active area.

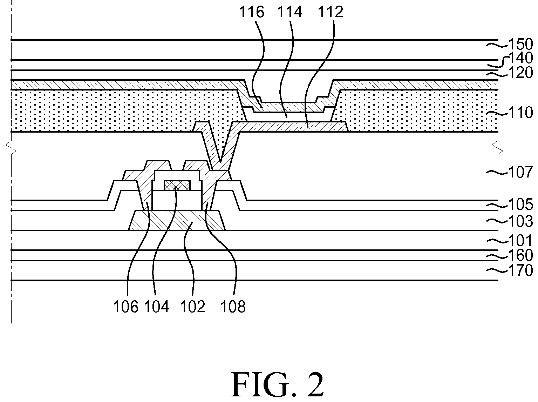

FIG. 2 is a cross-sectional view illustrating a part of an active area of an organic light emitting display device according to exemplary embodiments of the present disclosure.

Referring to FIG. 2, TFTs elements 102, 104, 106, and 108 and organic light emitting elements 112, 114, and 116 are disposed on the substrate 101.

The substrate 101 may be a glass or plastic substrate. In case of a plastic substrate, a polyimide-based or polycarbonate-based material may be used, and, thus, the substrate 101 may have flexibility.

The TFT may have a structure in which a semiconductor layer 102, a gate insulation film 103, a gate electrode 104, an interlayer insulation film 105, and source and drain electrodes 106 and 108 are disposed in sequence on the substrate 101.

The semiconductor layer 102 may be formed of polysilicon (p-Si). In this case, a predetermined area may be doped with impurities. Further, the semiconductor layer 102 may be formed of amorphous silicon (a-Si), or may be formed of various organic semiconductor materials such as pentacene. Further, the semiconductor layer 102 may be formed of oxide. If the semiconductor layer 102 is formed of p-Si, a-Si is formed and then crystallized into p-Si. As a crystallization method, various methods such as Rapid Thermal Annealing (RTA), Sequential Lateral Solidification (SLS) or the like may be used.

The gate insulation film 103 may be formed of an insulation material such as a silicon oxide film (SiOx) or a silicon nitride film (SiNx). Otherwise, the gate insulation film 103 may be formed of an organic insulation material or the like. The gate electrode 104 may be formed of various conductive materials such as Mg, Al, Ni, Cr, Mo, W, MoW, Au, or alloys thereof.

The interlayer insulation film 105 may be formed of an insulation material such as silicon oxide (SiOx) or silicon nitride (SiNx). Otherwise, the interlayer insulation film 105 may be formed of an organic insulation material or the like. A contact hole through which source and drain regions are exposed may be formed by selectively removing the interlayer insulation film 105 and the gate insulation film 103.

The source electrode 106 and drain electrode 108 are formed of a material used for the gate electrode 104 into a single layer or a multi-layer on the interlayer insulation film 105 so as to fill the contact hole.

A protective film 107 may be disposed on the TFT array. The protective layer 107 protects and flattens the TFT array. The protective film 107 may be formed of various materials and shapes. For example, the protective film 107 may be formed into an organic insulation film such as benzocyclobutene (BCB) or acryl, or an inorganic insulation film such as a silicon nitride film (SiNx) and a silicon oxide film (SiOx). Further, the protective film 107 may be formed into a single layer, a double-layer, or a multi-layer. As such, the protective film 107 can be modified in various ways.

The organic light emitting element includes a first electrode 112, an organic emission layer 114, and a second electrode 116 disposed in sequence. That is, the organic light emitting element includes the first electrode 112 formed on the protective film 107, the organic emission layer 114 disposed on the first electrode 112, and the second electrode 116 disposed on the organic emission layer 114.

The first electrode 112 is electrically connected to the drain electrode 108 of the TFT through the contact hole. The first electrode 112 may be formed of an opaque conductive material having a high reflectivity. For example, the first electrode 112 may be formed of Ag, Al, AINd, Au, Mo, W, Cr, or alloys thereof.

A bank 110 is formed on other areas than an emission area. Therefore, the bank 110 includes a bank hole through which the first electrode 112 corresponding to the emission area is exposed. The bank 110 may be formed of an inorganic insulation material such as a silicon nitride film (SiNx) and a silicon oxide film (SiOx), or an organic insulation material such as BCB, acryl-based resin, or imide-based resin.

The organic emission layer 114 is disposed on the first electrode 112 exposed by the bank 110. The organic emission layer 114 may include an emission layer, an electron injecting layer, an electron transporting layer, a hole transporting layer, a hole injecting layer, and the like. Such layers may be separate and distinct or may be integrated together in various ways.

The second electrode 116 is disposed on the organic emission layer 114. The second electrode 116 is formed of a transparent conductive material such as an indium tin oxide (ITO) or indium zinc oxide (IZO) and thus allows light generated from the organic emission layer 114 to pass through.

An upper encapsulation layer 120 is disposed on the second electrode 116. Herein, the upper encapsulation layer 120 may be an inorganic film formed of glass, metal, aluminum oxide (AlOx), or a silicon-based material, or may have a structure in which an organic film and an inorganic film are alternately laminated. The upper encapsulation layer 120 blocks permeation of oxygen and moisture in order to suppress oxidation of a luminescent material and an electrode material. If the organic light emitting element is exposed to moisture or oxygen, the emission area may be reduced, which is called pixel shrinkage, or so-called dark spots may occur in the emission area.

The barrier film 150 is disposed on the upper encapsulation layer 120 so as to entirely encapsulate the active area (A/A) of the substrate 101 including the organic light emitting element. The barrier film 150 may be a retardation film or an optically-isotropic film. If the barrier film 150 has an optically-isotropic property, the barrier film 150 transmits light incident into the barrier film 150 without phase retardation. Further, an organic film or an inorganic film (not illustrated) may be further disposed on or under the barrier film 150. In this case, the inorganic film may include a silicon oxide film (SiOx) or a silicon nitride film (SiOx). The organic film may include polymer materials such as acryl-based resin, epoxy-based resin, polyimide, or polyethylene. The organic film or the inorganic film formed on or under the barrier film 150 blocks permeation of moisture or oxygen.

An adhesive layer 140 may be disposed between the barrier film 150 and the upper encapsulation layer 120. The adhesive layer 140 bonds the upper encapsulation layer 120 and the barrier film 150. The adhesive layer 140 may be a thermally curable or naturally curable adhesive. For example, the adhesive layer 140 may be formed of a barrier pressure sensitive adhesive (B-PSA).

Meanwhile, a lower adhesive layer 160 and a lower encapsulation layer 170 may be formed in sequence under the substrate 101. The lower encapsulation layer 170 may be formed of one or more organic materials selected from polyethylene naphthalate (PEN), polyethylene terephthalate (PET), polyethylene ether phthalate, polycarbonate, polyarylate, polyether imide, polyether sulfonate, polyimide, or polyacrylate. The lower encapsulation layer 170 suppresses permeation of moisture or oxygen into the substrate 101.

The lower adhesive layer 160 is formed of a thermally curable or naturally curable adhesive, and bonds the substrate 101 and the lower encapsulation layer 170. For example, the lower adhesive layer 160 may be formed of an optical cleared adhesive (OCA).

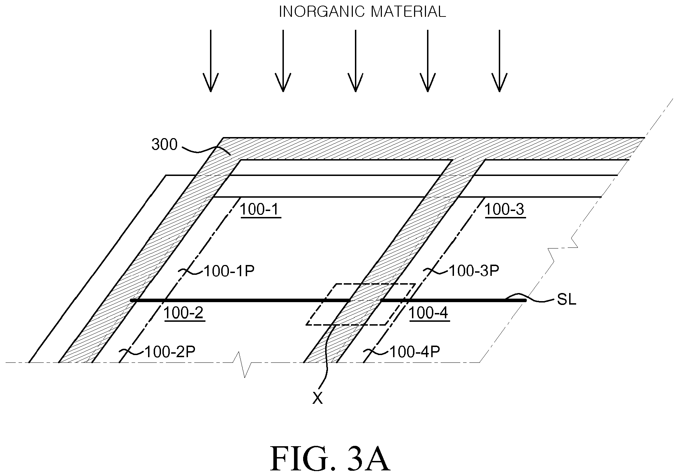

FIG. 3A through FIG. 3D are diagrams illustrating an organic light emitting display device and an encapsulation layer according to an exemplary embodiment not according to the present claimed invention.

FIG. 3A illustrates a part of a mother substrate on which a plurality of display panels (or cells) are manufactured and a part of a deposition mask 300. The deposition mask 300 is used for deposition of inorganic films 121-1 and 121-2 as one of encapsulation layers. During the deposition, an inorganic material is deposited on a portion (the substrate, a specific layer of the display device, etc.) corresponding to a passing portion (opening portion) of the mask 300. However, the inorganic material is not deposited on a portion corresponding to a shielding portion of the mask.

The mask illustrated in FIG. 3A shields pad areas 100-1P, 100-2P, 100-3P, and 100-4P of display devices 100-1, 100-2, 100-3, and 100-4 from deposition of an inorganic film. That is, the mask includes shielding portions corresponding to the pad areas 100-1P, 100-2P, 100-3P, and 100-4P of the respective display devices. Thus, in the respective display devices 100-1, 100-2, 100-3, and 100-4 on the mother substrate, an inorganic film is deposited on the entire surface (the active area and the inactive area around the active area) except the pad areas 100-1P, 100-2P, 100-3P, and 100-4P.

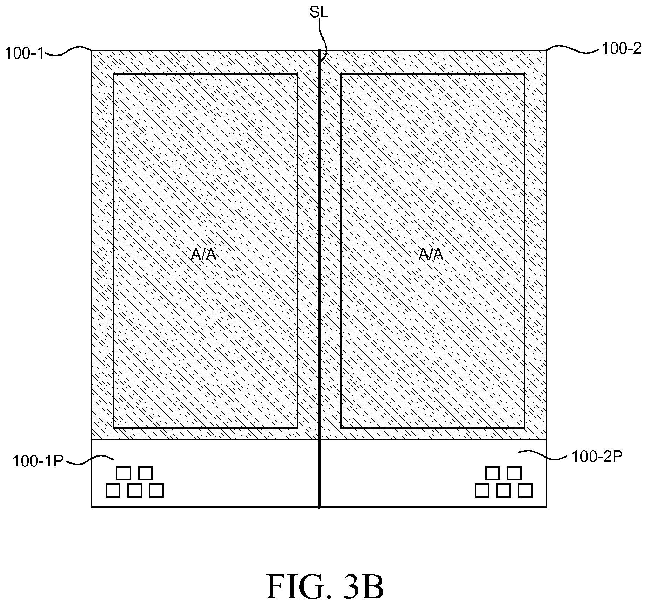

FIG. 3B illustrates the mother substrate on which the inorganic film is deposited entirely except the pad areas 100-1P and 100-2P of the respective display devices 100-1 and 100-2 through the process illustrated in FIG. 3A. For convenience in explanation, the two display device cells 100-1 and 100-2 are illustrated as being on the mother substrate. However, in an actual process, more display device cells may be deposed on the mother substrate. When all the processes including the deposition of the inorganic film to the mother substrate are ended, each of the display devices on the mother substrate is separated. In this case, a scribing process using a laser is performed.

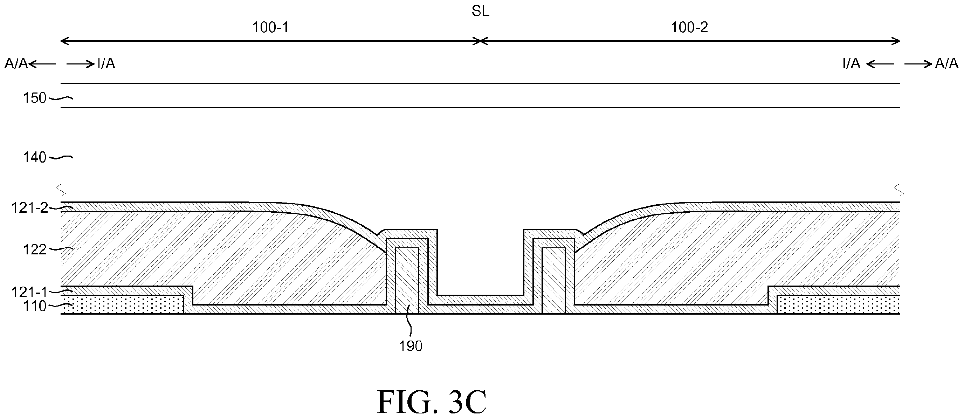

FIG. 3C illustrates a part of an encapsulation layer in the inactive area including the inorganic film deposited using the mask illustrated in FIG. 3A. Encapsulation layers 121-1, 122, and 121-2 illustrated in FIG. 3C are formed into a thin-film layer having a structure in which inorganic films (inorganic layers) and organic films (organic layers) are laminated in several folds or stacks. The reason why the encapsulation layers are formed into a thin-film layer laminated in several folds or stacks is to complicate a moving path of moisture or oxygen as compared with a single layer and thus make it difficult for moisture or oxygen to permeate. Inorganic films 121-1 and 121-2 may be formed of an aluminum (Al)-based material or a silicon (Si)-based material. The inorganic films blocks permeation of moisture or oxygen. The organic film 122 may include polymer materials such as acryl-based resin, epoxy-based resin, polyimide, or polyethylene. An organic film 122 flattens a surface of the inorganic film 121-1. If the organic film in liquid form is coated, a shielding structure 190 is present in the inactive area in order for the organic film not to flow too far toward an outer periphery of the display device. The shielding structure 190 may also be referred to as a dam.

A first inorganic layer 121-1 covers an upper surface of an organic light emitting element layer disposed in an active area. The first inorganic layer 121-1 may be deposited on the upper surface of the organic light emitting element layer through a process such as an atomic layer deposition (ALD) process, a chemical vapor deposition (CVD) process, or the like. As a material of the inorganic layer, an aluminum oxide (AlOx)-based material or a silicon (Si)-based material may be used. In case of the ALD process, Al₂O₃, SiOx, and the like, may be used. In case of the CVD process, SiNx, SiOx, SiON, and the like, may be used.

The organic layer 122 is disposed on the first inorganic layer 121-1. The organic layer 122 may be formed using epoxy or an acryl-based polymer. The organic layer 122 may be coated on the first inorganic layer 121-1 through vacuum screen printing (VSP), inkjet coating, and the like.

A second inorganic layer 121-2 is disposed on the organic layer 122 and entirely covers the organic layer 122. The second inorganic layer 121-2 may be formed of the same material as the first inorganic layer 121-1, or may be formed of a different material from the first inorganic layer 121-1. Furthermore, the first inorganic layer 121-1 and the second inorganic layer 121-2 contact each other in the first portion of the inactive area, in particular in the portion where the dam is located.

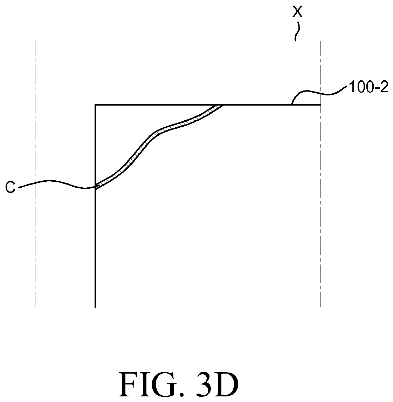

The inorganic layers 121-1 and 121-2 cover the entire surface (except the pad areas) of the display devices on the mother substrate as illustrated in FIG. 3B through the process illustrated in FIG. 3A. Therefore, when each of the display devices is cut/separated, the inorganic layers 121-1 and 121-2 are also scribed with a laser or the like. For this reason, the inorganic layers receive undesired impacts or jolts due to scribing. The impact causes damage (for example: crack) to the inorganic layers. The crack may spread (propagated) due to the characteristics of the inorganic layers and thus may serve as a moisture-permeation path. FIG. 3D illustrates a crack C generated and spread in any one display device 100-2 as described above.

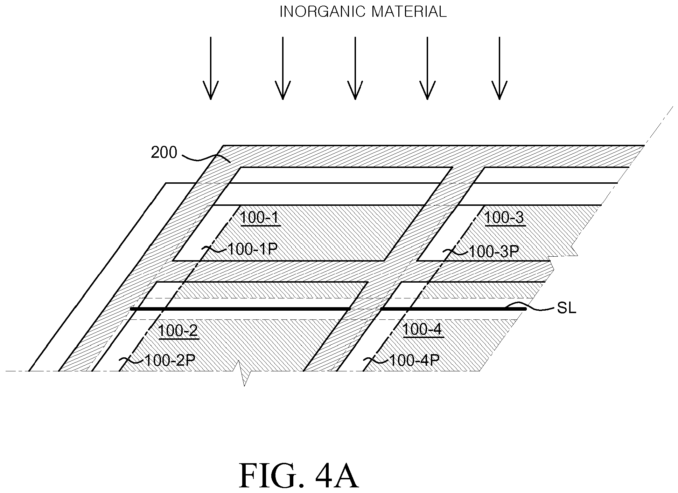

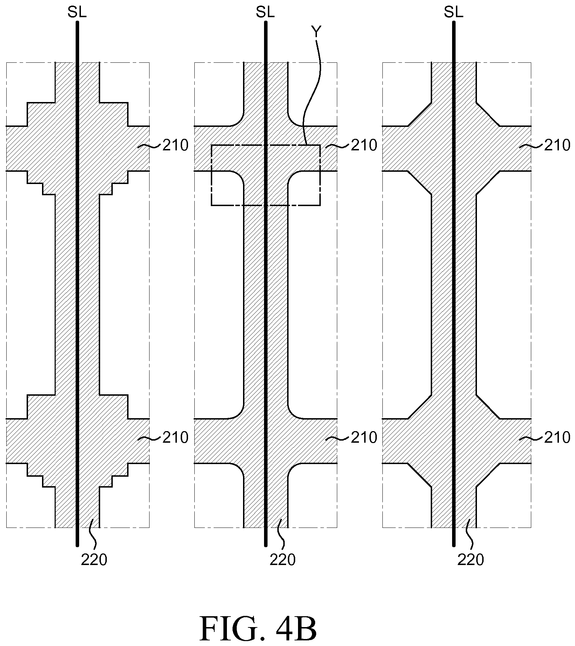

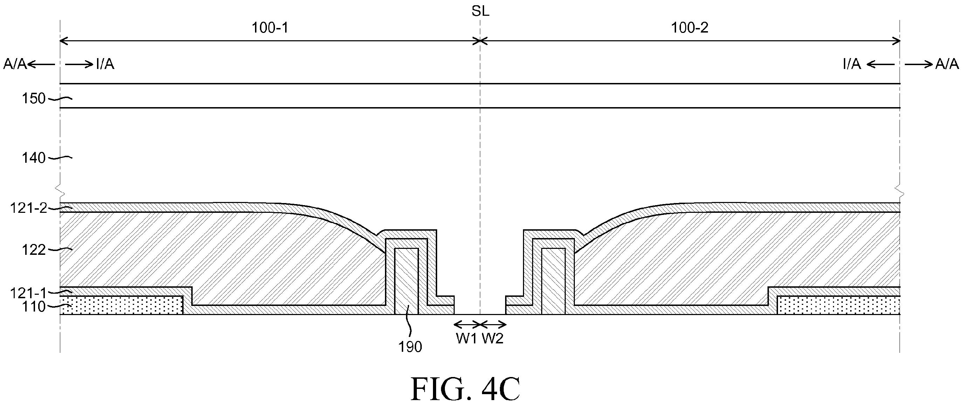

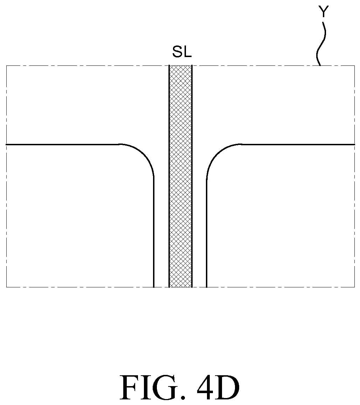

FIG. 4A through FIG. 4D are diagrams illustrating an organic light emitting display device according to another exemplary embodiment of the present disclosure. Figures 4B, 4C describe an embodiment according to the claimed invention. Figures 4A, 4D are not part of the claimed invention.

FIG. 4A illustrates a part of a mother substrate on which a plurality of display panels (or cells) are manufactured and a part of a deposition mask 200. For convenience in explanation, four display device cells are illustrated as being on the mother substrate. However, in an actual process, more display device cells may be deposed on the mother substrate.

The deposition mask 200 is used for deposition of an inorganic film as one of encapsulation layers. During the deposition, an inorganic material is deposited on a portion (the substrate, a specific layer of the display device, and the like) corresponding to a passing portion (opening portion) of the mask. However, the inorganic material is not deposited on a portion corresponding to a shielding portion of the mask. When all the processes including the deposition of the inorganic film to the mother substrate are ended, each of the display devices on the mother substrate is separated. In this case, a scribing process using a laser is performed.

The mask 200 shields some parts (predetermined areas corresponding to pad areas and scribing lines SL) in the inactive areas of the respective display devices 100-1, 100-2, 100-3, and 100-4 from deposition of an inorganic film. That is, the mask 200 includes shielding portions corresponding to the pad areas 100-1P, 100-2P, 100-3P, and 100-4P of the respective display devices and the scribing lines SL. Thus, in the respective display devices 100-1, 100-2, 100-3, and 100-4 on the mother substrate, an inorganic film is deposited on the entire surface except the pad areas 100-1P, 100-2P, 100-3P, and 100-4P and the scribing lines SL. One or more inorganic films deposited as such cover the entire active area and a part of the inactive area surrounding the active area. Particularly, the above-described inorganic film is deposited to cover only to a portion having a predetermined inward distance from an outermost periphery (cell end and boundary with an adjacent cell) of the inactive area. That is, the inorganic film is formed to the portion having a predetermined inward width from an outermost periphery of the display device. The outermost periphery of the display device corresponds to the scribing line SL. Therefore, the inorganic film deposited as illustrated in FIG. 4A is present only to an area spaced at a predetermined distance from the scribing line SL.

Accordingly, in the organic light emitting display device according to exemplary embodiments of the present disclosure, an inorganic film constituting an encapsulation layer is present only in a first portion (inner portion) of an inactive area adjacent to an active area. However, the inorganic film is not present in a second portion (outer portion and cell end portion) of the inactive area except the first portion. The second portion where the inorganic film is not deposited may be regarded as being disposed with a predetermined inward width from the outermost periphery of the organic light emitting display device. The second portion has a predetermined width which is enough to avoid an impact applied when the outermost periphery of the organic light emitting display device is cut. For example, the second portion has a width enough to avoid the spread of an impact applied when the outermost periphery of the organic light emitting display device is cut by laser scribing and damage (for example: crack) caused by the impact. For example, the second portion may have a width of 150 µm or more from the outermost periphery (or scribing line) of the organic light emitting display device.

Meanwhile, the inorganic film has a chamfered shape at one or more corners of the organic light emitting display device. Even if an impact is not directly applied to the inorganic film since the inorganic film is spaced from the scribing line SL, a crack caused by damage to a lower substrate (for example: glass) can be spread to the inorganic film. Therefore, the inorganic film has a round shape, in an example not being part of the claimed invention, a square shape, a stepped shape at a corner in order to place the inorganic film as far as possible from each corner of a cell to which the highest impact of scribing is applied.

As such, the inorganic film configured to avoid an impact generated when the display device (cell) is cut may be formed using a mask to be described below.

FIG. 4B, according to the claimed invention, illustrates a mask which can be applied to exemplary embodiments of the present disclosure. The mask 200 includes a passing portion (opening portion) corresponding to a portion coated with the inorganic film and a shielding portion corresponding to a portion which is not coated with the inorganic film. In exemplary embodiments of the present disclosure, the shielding portion of the mask 200 corresponds to a pad area of the display device and a part of the inactive area. For example, in the mask 200, a shielding portion 210 in a first direction (transverse direction) corresponds to the pad area of the display device. Further, a shielding portion 220 in a second direction (longitudinal direction) corresponds to a part of the inactive area extended in the second direction of the display device. Herein, the shielding portion 220 in the second direction may correspond up to a portion (second portion) having a predetermined inward width from the outermost periphery of the organic light emitting display device. The shielding portion 220 may have a width of 300 µm (150 µm × 2) or more.

Meanwhile, the passing portion of the mask 200 may correspond to the active area and the first portion of the inactive area of the display device. The first portion refers to a portion which is an inner portion of the inactive area adjacent to the active area and coated with the inorganic film. The second portion refers to a portion which is the other portion (outer portion) of the inactive area except the first portion and not coated with the inorganic film.

Corners of the passing portion (opening portion) where the shielding portion is not present in the mask 200 have a chamfered shape. The chamfered shape may be a round shape, in an example not being part of the claimed invention, or is a square shape, a stepped shape, according to the claimed invention. The passing portion corresponds to an area of the display device where the inorganic film is deposited. Therefore, at least the inorganic film of the display device has a chamfered shape at one or more corners.

FIG. 4C illustrates a part of an encapsulation layer in the inactive area including the inorganic film deposited using the mask illustrated in FIG. 4B. The encapsulation layers 121-1, 122, and 121-2 illustrated in FIG. 4B are formed into a thin-film layer having a structure in which inorganic films (inorganic layers) and organic films (organic layers) are laminated in several folds or stacks. The inorganic film may be formed of oxide, nitride, carbide-based metal materials (Al₂O₃ and SiNx as representative examples). The inorganic film blocks permeation of moisture or oxygen from the outside. The organic film may include polymer materials such as acryl-based resin, epoxy-based resin, polyimide, or polyethylene. The organic film 122 flattens the surface of the inorganic film 121-1. If the organic film in liquid form is coated, the shielding structure 190 is present in the inactive area in order for the organic film not to flow too far toward an outer periphery of the display device. The shielding structure 190 may also be referred to as a dam and typically has a height of 2 to 3 µm. As illustrated in FIG. 4C, even if the organic film 122 overflows beyond a target zone during a coating process, the organic film 122 does not flow further to the outside due to the shielding structure 190.

The first inorganic film 121-1 covers an upper surface of an organic light emitting element layer disposed in the active area. The first inorganic layer 121-1 may be deposited on the upper surface of the organic light emitting element layer through a process such as an atomic layer deposition (ALD) process, a chemical vapor deposition (CVD) process, or the like. As a material of the inorganic layer, an aluminum oxide (AlOx)-based material or a silicon (Si)-based material may be used. In case of the ALD process, Al₂O₃, SiOx, and the like, may be used. In case of the CVD process, SiNx, SiOx, SiON, and the like, may be used.

The organic layer 122 is disposed on the first inorganic layer 121-1. The organic layer 122 may be formed using a material, such as epoxy or an acryl-based polymer, having the viscosity of 20 or less. The organic layer 122 may be coated on the first inorganic layer 121-1 through vacuum screen printing (VSP). The VSP is a process of coating a fluid material on a target object by allowing the fluid material to pass through a mask or screen manufactured along a coating shape. Otherwise, the organic film 122 may be coated on the inorganic film 121-1 through inkjet coating. The inkjet coating is a process of coating an organic film in liquid form on a coating area while moving an injection nozzle above the coating area (or fixing the nozzle and moving a target object). The inkjet coating does not need a mask and thus does not apply an impact to the target object during a coating process. Therefore, the inkjet coating is advantageous in forming a thinner film (for example: 10 µm or less). Further, the inkjet coating is advantageous in applying different design values (coating ranges) for respective organic film since it does not need to use the same mask for all the organic films. The second inorganic film 121-2 is disposed on a first organic film 122-1 and entirely covers the first organic film 122-1. The second inorganic film 121-2 may be formed of the same material as the first inorganic layer 121-1, or may be formed of a different material from the first inorganic layer 121-1. Furthermore, the first inorganic layer 121-1 and the second inorganic layer 121-2 contact each other in the first portion of the inactive area, in particular in the portion where the dam is located.

It can be seen from FIG. 4C that the first and second inorganic films are not disposed within a predetermined space around the scribing line SL. A portion around the scribing line SL where the inorganic films are not deposited may be regarded as being disposed with a predetermined inward width (w1, w2) from the outermost periphery (cell end) of the organic light emitting display device. The predetermined width refers to a width sufficient to avoid an impact applied when the outermost periphery of the organic light emitting display device is cut. For example, the second portion has a width sufficient to avoid the spread of an impact applied when the outermost periphery of the organic light emitting display device is cut by laser scribing and damage (for example: crack) caused by the impact. For an example, each width (w1, w2) of the second portion may be 150 µm or more. Therefore, the mask for manufacturing a display device having the structure of the inorganic films in FIG. 4C includes a shielding portion having a width of 300 µm (150 µm × 2) or more and corresponding to the second portion where the inorganic film is not deposited.

Meanwhile, the inorganic film has a chamfered shape at one or more corners of the organic light emitting display device. Even if an impact is not directly applied to the inorganic film since the inorganic film is spaced from the scribing line SL, a crack caused by damage to a lower substrate (for example: glass) can be spread to the inorganic film. Therefore, the inorganic film has a round shape, in an example not forming part of the claimed invention, a square shape, a stepped shape, according to the claimed invention, at a corner in order to place the inorganic film as far as possible from each corner of a cell to which the highest impact of scribing is applied. FIG. 4D is an enlarged view of a portion Y of FIG. 4B and illustrates a corner of the organic light emitting display device chamfered into a round shape, in an example not forming part of the claimed invention.

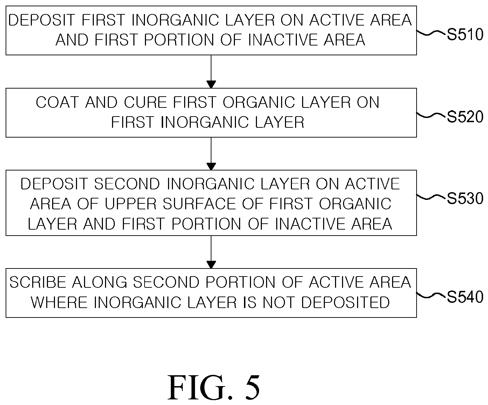

FIG. 5 is a flowchart illustrating a manufacturing method of an organic light emitting display device according to exemplary embodiments of the present disclosure.

According to the manufacturing method, a plurality of cells of an organic light emitting display device may be manufactured on a mother substrate at the same time. Particularly, FIG. 5 illustrates a flowchart as part of a process of forming an encapsulation layer included in the manufacturing method of an organic light emitting display device. The encapsulation layer has a face seal structure that entirely covers the upper surface of an organic light emitting element and suppresses permeation of oxygen and/or moisture. Also, the encapsulation layer has a multi-layer structure in which inorganic thin layers (inorganic thin films) and organic thin layers (organic thin films) are laminated in several folds or stacks. In the face seal structure, the one or more inorganic films are disposed only to a portion having a predetermined inward distance (for example: 150 µm or more) from the outermost periphery of the organic light emitting display device. Thus, the one or more inorganic films have a structure configured to minimize damage caused by an impact applied when the outermost periphery of the display device is cut. That is, in the one or more inorganic films, the occurrence and spread of a crack caused by the impact can be minimized.

In the face seal structure, the one or more inorganic films and the one or more organic films may include a first inorganic film covering the upper surface of the organic light emitting element layer disposed in the active area, a first organic film disposed on the first inorganic film, and a second inorganic film disposed on the first organic film and entirely covering the first organic film. Herein, the first and second inorganic films may be formed of one or more materials among oxide, nitride, carbide-based metal materials.

In the manufacturing method, a first inorganic layer is deposited in the active area (the upper surface of the organic light emitting element layer) and a part of the inactive area (first portion) adjacent to the active area (S710). The first inorganic layer covers the upper surface of the organic light emitting element layer disposed in the active area. During this process, an atomic layer deposition (ALD) process, a chemical vapor deposition (CVD) process, or the like may be used. For deposition of the first inorganic layer, the CVD process, particularly plasma enhanced chemical vapor deposition (PECVD) process, may be used. In the PECVD process, an electron that obtains high energy from plasma collides with gas molecules in a neutral state and dissociates the gas molecules and the dissociated gas molecules react with each other. In the PECVD process, a gas is injected under a low pressure and plasma is used as reaction energy. Therefore, deposition can be performed at a low temperature. As a material of the first inorganic layer, Al₂O₃, SiOx, and the like, may be used in case of the ALD process. Further, SiNx, SiOx, SiON, and the like, may be used in case of the CVD process. During the deposition of the first inorganic layer, the mask 200 illustrated in FIG. 4A and 4B may be used. That is, the mask including the shielding portion having a shielding area corresponding to the second portion (cell end or scribing area) of the inactive area except the first portion and the passing portion having a passing area corresponding to the active area and the first portion may be used. Due to this mask, the first inorganic layer is not coated on the second portion.

Then, a first organic layer is coated and cured on the first inorganic layer (S520). The first organic layer may be coated through inkjet coating. In this case, the first organic layer may have a thickness of 10 µm or less. The organic layer may be formed using a material, such as epoxy or an acryl-based polymer, having the viscosity of 20 or less.

Then, a second inorganic layer is deposited on an upper surface of the cured first organic layer (S530). The second inorganic layer may be formed of the same material as the first inorganic layer, or may be formed of a different material from the first inorganic layer. Further, the second inorganic layer may be formed to a smaller thickness than the first inorganic layer. During the deposition of the second inorganic layer, a mask of the same kind as the mask used for the deposition of the first inorganic layer may be used. Therefore, the second inorganic layer either is not coated on the second portion. A second organic layer, a third organic layer, and the like may be further laminated alternately on the second inorganic layer.

An adhesive layer 140 may be placed on an upper end of the face seal configured as described above, and a barrier film 150 may be laminated on the adhesive layer.

When the process to the mother substrate is ended, each display device is scribed (S540). In this case, the scribing process is performed along the second portion where the first and second inorganic layers are not deposited. Thus, an impact is not applied to the first and second inorganic layers.

The foregoing description and the accompanying drawings are provided only to illustrate the technical conception of the present disclosure, but it will be understood by a person having ordinary skill in the art that various modifications and changes such as combinations, separations, substitutions, and alterations of the components may be made without departing from the scope of the present invention as defined in the appended claims. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. The protective scope of the present disclosure should be construed based on the following claims.

## Claims

1. An organic light emitting display device comprising:
an organic light emitting element layer (112, 114, 116) in an active area (A/A); and
a multi-layer face seal structure covering the organic light emitting element layer (112, 114, 116), the multi-layer face seal structure comprising one or more inorganic films (121-1, 121-2) and one or more organic films (122), wherein the one or more inorganic films (121-1, 121-2) and the one or more organic films (122) covering the entire active area (A/A) and a part of an inactive area (I/A) surrounding the active area (A/A), and
the one or more inorganic films (121-1, 121-2) are disposed only at a portion having a predetermined inward distance from an outermost periphery of the inactive area (I/A),
**characterized in that** the one or more inorganic films (121-1, 121-2) have a chamfered shape at one or more corners of the organic light emitting display device (100-1, 100-2, 100-3, 100-4), such that, when viewed in a plan view, a square shape portion is cut at at least one of the corners between two adjoining sides of the one or more inorganic films (121-1, 121-2) forming a right angle, or a slope cut is formed at at least one of the corners between two adjoining sides of the one or more inorganic films (121-1, 121-2) forming a right angle, or a stepped shape is formed at at least one of the corners between two adjoining sides of the one or more inorganic films (121-1, 121-2) forming a right angle.

2. The organic light emitting display device according to claim 1, wherein the multi-layer face seal structure comprises an encapsulation layer (120) covering the organic light emitting element layer (112, 114, 116), wherein the encapsulation layer (120) includes the one or more inorganic films (121-1, 121-2) and one or more organic films (122).

3. The organic light emitting display device according to claim 1 or 2, wherein the one or more inorganic films (121-1, 121-2) are disposed in a first portion of the inactive area (I/A) adjacent to the active area (A/A), and are not disposed in a second portion of the inactive area (I/A), wherein the second portion is disposed with a predetermined inward width of an outermost periphery of the organic light emitting display device (100-1, 100-2, 100-3, 100-4).

4. The organic light emitting display device according to claim 3, wherein the second portion has the width of 150 µm or more.

5. The organic light emitting display device according to any one of the preceding claims, wherein the one or more inorganic films (121-1, 121-2) are formed of inorganic materials deposited using a mask (200) including a shielding portion (210, 220) corresponding to a portion having a predetermined inward width from the outermost periphery of the organic light emitting display device (100-1, 100-2, 100-3, 100-4) and a passing portion corresponding to the active area (A/A) and the inactive area (I/A) except the shielding area.

6. The organic light emitting display device according to any one of the preceding claims, wherein the one or more inorganic films (121-1, 121-2) and the one or more organic films (122) include a first inorganic film (121-1) covering an upper surface of an organic light emitting element layer (112, 114, 116) in an active area (A/A), a first organic film (122) on the first inorganic film (121-1), and a second inorganic film (121-2) on the first organic film (122) and entirely covering the first organic film (122).

7. The organic light emitting display device according to any one of the preceding claims, wherein the first inorganic film (121-1) and the second inorganic film (121-2) are formed of one or more materials among oxide, nitride, carbide-based metal.

8. The organic light emitting display device according to claim 2, wherein the encapsulation layer (120) is coated such that a periphery of the encapsulation layer (120) is disposed between a periphery of a barrier film (150) and a periphery of the active area (A/A).

9. The organic light emitting display device according to any one of the preceding claims, wherein a lower adhesive layer (160) and a lower encapsulation layer (170) are formed in sequence under the substrate (101).

10. The organic light emitting display device according to any one of the preceding claims, wherein a shielding structure (190) is present in the inactive area (I/A).

11. A manufacturing method of an organic light emitting display device, comprising:
depositing (S510) a first inorganic film (121-1) in an active area (A/A) and in a first portion of an inactive area (I/A) adjacent to the active area (A/A);
coating (S520) a first organic film (122) on the first inorganic film (121-1);
curing the first organic film (122); and
depositing (S530) a second inorganic film (121-2) in the active area (A/A) of an upper surface of the cured first organic film (122) and in the first portion of the inactive area (I/A),
wherein the depositing of the first inorganic film (121-1) and the depositing of the second inorganic film (121-2) include depositing configuration materials of the first inorganic film and the second inorganic film using a mask (200) including a shielding portion (210, 220) having a shielding area corresponding to a second portion of the inactive area (I/A) except the first portion and a passing portion having a passing area corresponding to the active area (A/A) and the first portion,
wherein corners of the passing portion where the shielding portion is not present in the mask (200) have a chamfered shape, such that, when viewed in a plan view, a square shape portion is cut at at least one of the corners between two adjoining sides of the inorganic films (121-1, 121-2) forming a right angle, or a slope cut is formed at at least one of the corners between two adjoining sides of the inorganic films (121-1, 121-2) forming a right angle, or a stepped shape is formed at at least one of the corners between two adjoining sides of the inorganic films (121-1, 121-2) forming a right angle.

## Patentansprüche

1. Organische lichtemittierende Anzeigevorrichtung, die umfasst:
eine Schicht eines organischen lichtemittierenden Elements (112, 114, 116) in einem aktiven Bereich (A/A); und
eine Mehrschicht-Gleitring-Dichtungsstruktur, die die Schicht eines organischen lichtemittierenden Elements (112, 114, 116) bedeckt, wobei die Mehrschicht-Gleitring-Dichtungsstruktur eine oder mehrere anorganische Schichten (121-1, 121-2) und eine oder mehrere organische Schichten (122) umfasst, wobei die eine oder die mehreren anorganischen Schichten (121-1, 121-2) und die eine oder die mehreren organischen Schichten (122) den gesamten aktiven Bereich (A/A) und einen Abschnitt eines inaktiven Bereichs (I/A), der den aktiven Bereich (A/A) umgibt, bedecken, und
die eine oder die mehreren anorganischen Schichten (121-1, 121-2) nur in einem Abschnitt mit einem vorgegebenen Innenabstand von einem äußersten Umfang des inaktiven Bereichs (I/A) angeordnet sind,
**dadurch gekennzeichnet, dass**
die eine oder die mehreren anorganischen Schichten (121-1, 121-1) eine abgeschrägte Form an einer oder mehreren Ecken der organischen lichtemittierenden Anzeigevorrichtung (100-1, 100-2, 100-3, 100-4) besitzen, derart, dass dann, wenn sie in einer Draufsicht betrachtet werden, ein Abschnitt einer quadratischen Form an mindestens einer Ecke zwischen zwei benachbarten Seiten der einen oder der mehreren anorganischen Schichten (121-1, 121-2), die einen rechten Winkel bilden, ausgeschnitten ist, oder ein Schrägausschnitt an mindestens einer der Ecken zwischen benachbarten Seiten des einen oder der mehreren anorganischen Schichten (121-1, 121-2), die einen rechten Winkel bilden, gebildet ist oder eine gestufte Form an mindestens einer der Ecken zwischen benachbarten Seiten der einen oder der mehreren anorganischen Schichten (121-1, 121-2), die einen rechten Winkel bilden, gebildet ist.

2. Organische lichtemittierende Anzeigevorrichtung nach Anspruch 1, wobei die Mehrschicht-Gleitring-Dichtungsstruktur eine Einkapselungsschicht (120) umfasst, die die Schicht eines organischen lichtemittierenden Elements (112, 114, 116) bedeckt, wobei die Einkapselungsschicht (120) die eine oder die mehreren anorganischen Schichten (121-1, 121-2) und eine oder mehrere organische Schichten (122) enthält.

3. Organische lichtemittierende Anzeigevorrichtung nach Anspruch 1 oder 2, wobei die eine oder die mehreren anorganischen Schichten (121-1, 121-2) in einem ersten Abschnitt des inaktiven Bereichs (I/A) benachbart zu dem aktiven Bereich (A/A) angeordnet sind und nicht in einem zweiten Abschnitt des inaktiven Bereichs (I/A) angeordnet sind, wobei der zweite Abschnitt mit einer vorgegebenen Weite einwärts von einem äußersten Umfang der organischen lichtemittierenden Anzeigevorrichtung (100-1, 100-2, 100-3, 100-4) angeordnet ist.

4. Organische lichtemittierende Anzeigevorrichtung nach Anspruch 3, wobei der zweite Abschnitt eine Breite von 150 µm oder mehr besitzt.

5. Organische lichtemittierende Anzeigevorrichtung nach einem der vorhergehenden Ansprüche, wobei die eine oder die mehreren anorganischen Schichten (121-1, 121-2) aus anorganischen Materialien gebildet sind, die unter Verwendung einer Maske (200) aufgebracht werden, die einen Abschirmteil (210, 220), der einem Abschnitt mit einer vorgegebenen Weite einwärts von einem äußersten Umfang der organischen lichtemittierenden Anzeigevorrichtung (100-1, 100-2, 100-3, 100-4) entspricht, und einen Durchlassteil, der dem aktiven Bereich (A/A) und dem inaktiven Bereich (I/A) mit Ausnahme des Abschirmbereichs entspricht, enthält.

6. Organische lichtemittierende Anzeigevorrichtung nach einem der vorhergehenden Ansprüche, wobei die eine oder die mehreren anorganischen Schichten (121-1, 121-2) und die eine oder die mehreren organischen Schichten (122) eine erste anorganische Schicht (121-1), die eine obere Fläche einer Schicht eines organischen lichtemittierenden Elements (112, 114, 116) in einem aktiven Bereich (A/A) bedeckt, eine erste organische Schicht (122) auf der ersten anorganischen Schicht (121-1) und eine zweite anorganische Schicht (121-2) auf der ersten organischen Schicht (122), die die erste organische Schicht (122) vollständig bedeckt, enthalten.

7. Organische lichtemittierende Anzeigevorrichtung nach einem der vorhergehenden Ansprüche, wobei die erste anorganische Schicht (121-1) und die zweite anorganische Schicht (121-2) aus einem oder mehreren Materialien, die Oxid, Nitrid und karbidbasiertes Metall umfassen, gebildet sind.

8. Organische lichtemittierende Anzeigevorrichtung nach Anspruch 2, wobei die Einkapselungsschicht (120) derart beschichtet ist, dass ein Umfang der Einkapselungsschicht (120) zwischen einem Umfang einer Barrierenschicht (150) und einem Umfang des aktiven Bereichs (A/A) angeordnet ist.

9. Organische lichtemittierende Anzeigevorrichtung nach einem der vorhergehenden Ansprüche, wobei eine untere Haftschicht (160) und eine untere Einkapselungsschicht (170) nacheinander unter dem Substrat (101) gebildet sind.

10. Organische lichtemittierende Anzeigevorrichtung nach einem der vorhergehenden Ansprüche, wobei in dem inaktiven Bereich (I/A) eine Abschirmstruktur (190) vorhanden ist.

11. Herstellungsverfahren einer organischen lichtemittierenden Anzeigevorrichtung, das Folgendes umfasst:
Ablagern (S510) einer ersten anorganischen Schicht (121-1) in einem aktiven Bereich (A/A) und in einem ersten Abschnitt eines inaktiven Bereichs (I/A) benachbart zu dem aktiven Bereich (A/A);
Beschichten (S520) der ersten anorganischen Schicht (121-1) mit einer ersten organischen Schicht (122);
Aushärten der ersten organischen Schicht (122); und
Ablagern (S530) einer zweiten organischen Schicht (121-2) in dem aktiven Bereich (A/A) einer oberen Fläche der ausgehärteten ersten organischen Schicht (122) und in dem ersten Abschnitt des inaktiven Bereichs (I/A),
wobei das Ablagern der ersten anorganischen Schicht (121-1) und das Ablagern der zweiten anorganischen Schicht (121-2) umfassen, Konfigurationsmaterialien der ersten anorganischen Schicht und der zweiten anorganischen Schicht unter Verwendung einer Maske (200), die einen Abschirmteil (210, 220) mit einem Abschirmbereich, der einem zweiten Abschnitt des inaktiven Bereichs (I/A) mit Ausnahme des ersten Abschnitts entspricht, und einen Durchlassteil mit einem Durchlassbereich, der dem aktiven Bereich (A/A) und dem ersten Abschnitt entspricht, aufweist, abzulagern,
wobei Ecken des Durchlassteils, wo der Abschirmteil in der Maske (200) nicht vorhanden ist, eine abgeschrägte Form besitzen, derart, dass dann, wenn sie in Draufsicht betrachtet werden, ein Abschnitt einer quadratischen Form an mindestens einer der Ecken zwischen zwei benachbarten Seiten der anorganischen Schichten (121-1, 121-2), die einen rechten Winkel bilden, gebildet ist, oder ein Schrägausschnitt an mindestens einer der Ecken zwischen zwei benachbarten Seiten der anorganischen Schichten (121-1, 12-2), die einen rechten Winkel bilden, gebildet ist oder eine gestufte Form an mindestens einer der Ecken zwischen zwei benachbarten Seiten der anorganischen Schichten (121-1, 121-2), die einen rechten Winkel bilden, gebildet ist.

## Revendications

1. Dispositif d'affichage électroluminescent organique comportant :
une couche d'éléments électroluminescents organiques (112, 114, 116) dans une zone active (A/A) ; et
une structure d'étanchéité faciale multicouche recouvrant la couche d'éléments électroluminescents organiques (112, 114, 116), la structure d'étanchéité faciale multicouche comportant un ou plusieurs films inorganiques (121-1, 121-2) et un ou plusieurs films organiques (122), dans lequel le ou les films inorganiques (121-1, 121-2) et le ou les films organiques (122) recouvrent la zone active (A/A) complète et une portion d'une zone inactive (I/A) entourant la zone active (A/A) ; et
le ou les films inorganiques (121-1, 121-2) sont disposés uniquement sur une partie ayant une distance vers l'intérieur prédéterminée par rapport à une périphérique la plus à l'extérieur de la zone inactive (I/A),
**caractérisé en ce que** le ou les films inorganiques (121-1, 121-2) ont une forme chanfreinée à un ou plusieurs coins du dispositif d'affichage électroluminescent organique (100-1, 100-2, 100-3, 100-4), de telle sorte que, lorsqu'elle est vue en vue de dessus, une partie de forme carrée est coupée à au moins un des coins entre deux côtés adjacents du ou des films inorganiques (100-1, 100-2, 100-3, 100-4) en formant un angle droit, ou une coupe inclinée est formée à au moins un des coins entre deux côtés adjacents du ou des films inorganiques (121-1, 121-2) en formant un angle droit, ou une forme étagée est formée à au moins un des coins entre deux côtés adjacents du ou des films inorganiques (121-1, 121-2) en formant un angle droit.

2. Dispositif d'affichage électroluminescent organique selon la revendication 1, dans lequel la structure d'étanchéité faciale multicouche comporte une couche d'encapsulation (120) recouvrant la couche d'éléments électroluminescents organiques (112, 114, 116), dans lequel la couche d'encapsulation (120) inclut le ou les films inorganiques (121-1, 121-2) et un ou plusieurs films organiques (122).

3. Dispositif d'affichage électroluminescent organique selon la revendication 1 ou 2, dans lequel le ou les films inorganiques (121-1, 121-2) sont disposés dans une première partie de la zone inactive (I/A) adjacente à la zone active (A/A), et ne sont pas disposés dans une seconde partie de la zone inactive (I/A), dans lequel la seconde partie est disposée avec une largeur vers l'intérieur prédéterminée sur une périphérie la plus à l'extérieur du dispositif d'affichage électroluminescent organique (100-1, 100-2, 100-3, 100-4).

4. Dispositif d'affichage électroluminescent organique selon la revendication 3, dans lequel la seconde partie a la largeur de 150 µm ou plus.

5. Dispositif d'affichage électroluminescent organique selon l'une quelconque des revendications précédentes, dans lequel le ou les films inorganiques (121-1, 121-2) sont formés de matériaux inorganiques déposés en utilisant un masque (200) incluant une partie d'écran (210, 220) correspondant à une partie ayant une largeur vers l'intérieur prédéterminée par rapport à la périphérie la plus à l'extérieur du dispositif d'affichage électroluminescent organique (100-1, 100-2, 100-3, 100-4) et une partie de passage correspondant à la zone active (A/A) et à la zone inactive (I/A) à l'exception de la zone d'écran.

6. Dispositif d'affichage électroluminescent organique selon l'une quelconque des revendications précédentes, dans lequel le ou les films inorganiques (121-1, 121-2) et le ou les films organiques (122) incluent un premier film inorganique (121-1) recouvrant une surface supérieure de la couche d'éléments électroluminescents organiques (112, 114, 116) dans une zone active (A/A), un premier film organique (122) sur le premier film inorganique (121-1), et un second film inorganique (121-2) sur le premier film organique (122) et recouvrant entièrement le premier film organique (122).

7. Dispositif d'affichage électroluminescent organique selon l'une quelconque des revendications précédentes, dans lequel le premier film inorganique (121-1) et le second film inorganique (121-2) sont formés d'un ou plusieurs matériaux parmi un oxyde, un nitrure, un métal à base de carbure.

8. Dispositif d'affichage électroluminescent organique selon la revendication 2, dans lequel la couche d'encapsulation (120) est déposée de telle sorte qu'une périphérie de la couche d'encapsulation (120) est disposée entre une périphérie d'un film barrière (150) et une périphérie de la zone active (A/A).

9. Dispositif d'affichage électroluminescent organique selon l'une quelconque des revendications précédentes, dans lequel une couche adhésive inférieure (160) et une couche d'encapsulation inférieure (170) sont formées l'une après l'autre sous le substrat (101).

10. Dispositif d'affichage électroluminescent organique selon l'une quelconque des revendications précédentes, dans lequel une structure d'écran (190) est présente dans la zone inactive (I/A).

11. Procédé de fabrication un dispositif d'affichage électroluminescent organique, comportant les étapes consistant à :
déposer (S510) un premier film inorganique (121-1) dans une zone active (A/A) et dans une première partie d'une zone inactive (I/A) adjacente à la zone active (A/A) ;
déposer (S520) un premier film organique (122) sur le premier film inorganique (121-1) ;
durcir le premier film organique (122) ; et
déposer (S530) un second film inorganique (121-2) dans la zone active (A/A) d'une surface supérieure du premier film organique durci (122) et dans la première partie de la zone inactive (I/A),
dans lequel le dépôt du premier film inorganique (121-1) et le dépôt du second film inorganique (121-2) incluent le dépôt de matériaux de configuration du premier film inorganique et du second film inorganique en utilisant un masque (200) incluant une partie d'écran (210, 220) ayant une zone d'écran correspondant à une seconde partie de la zone inactive (I/A) à l'exception de la première partie et une partie de passage ayant une zone de passage correspondant à la zone active (A/A) et à la première partie,
dans lequel des coins de la partie de passage où la partie d'écran n'est pas présente dans le masque (200) ont une forme chanfreinée, de telle sorte que, lorsqu'elle est vue en vue de dessus, une partie de forme carrée est coupée à au moins un des coins entre deux côtés adjacents des films inorganiques (121-1, 121-2) en formant un angle droit, ou une coupe inclinée est formée à au moins un des coins entre deux côtés adjacents des films inorganiques (121-1, 121-2) en formant un angle droit, ou une forme étagée est formée à au moins un des coins entre deux côtés adjacents des films inorganiques (121-1, 121-2) en formant un angle droit.
